# EUROPEAN PATENT APPLICATION

(11) **EP 4 703 793 A1**
(43) Date of publication of application: **04.03.2026**
(21) Application number: 24196857.7
(22) Date of filing: 28.08.2024
(51) Int. Cl.: G03F 7/00

(54) **LASER WRITING WITH A NON-CONSTANT EXPOSURE VELOCITY**

(71) Applicant: MYCRONIC AB, 183 03 Täby (SE)
(72) Inventor: Glimtoft, Martin, 125 58 Älvsjö (SE); Walther, Jonas, 169 37 Solna (SE)
(74) Representative: AWA Sweden AB

(57) **Abstract**

There is disclosed herein a method for controlling a laser writer (100), comprising moving a printing head (102) in a scan direction (X) relative to a printing substrate (104), wherein the movement of the printing head (102) has a non-constant velocity profile, and directing one or more laser beams (106) through a spatial light modulator, SLM (108), and towards the printing substrate (104). The method comprises controlling the intensity of the one or more laser beams (106) directed through the SLM (108) according to one or more position triggers corresponding to predetermined positions of the printing head (102) relative to the printing substrate (104), such that the SLM (108) adopts an SLM array pattern corresponding to a printing pattern to be printed at a location on the printed substrate (104) when the printing head (102) is at said location on the printed substrate (104).

## Description

### Technical Field

The present disclosure relates to laser writing for creating micro- or nano-scale surface patterns, which may be used in microlithography systems or the like. More particularly, the present disclosure relates to a method for controlling a laser writer, and a laser writer that carries out such a method.

### Background

In the field of pattern generation, such as in mask printing, optical elements may be employed to induce splitting, changes in intensity, and/or deflection of one or more laser beams when imprinting a pattern onto a printing substrate like a photo-sensitive resist. These optical elements may include a modulating optic such as a spatial light modulator (SLM), which can modify one or more laser beams that are directed towards a printing head that is scanned across the printing substrate to generate the pattern.

The modulating optic, the SLM, modulates the intensity of each of the one or more laser beams according to the desired pattern, using an array of optical elements (e.g. mirrors) individually controllable to either (partially) block or transmit/reflect light, to form a 1-dimensional (1D) or 2D grid of pixels. A (pulsed) laser beam uniformly illuminates the SLM, resulting in the pattern formed by the optical elements to be "stamped" onto the substate. Pixels of different intensity levels may be formed by repeated exposure or partial blocking/transmission.

Thus, a laser writer can generate a pattern by moving the printing head relative to the printing substrate, in a scan direction, with the pattern encoded into a laser beam by the SLM, optionally while carrying out a number of repeat exposures using the SLM.

However, as the demand for printed substrates increases, there may be a desire to increase the speed at which they can be printed, without impacting the accuracy of the pattern printed thereon. The use of an SLM in this context provides a promising avenue for achieving this goal.

### Summary

Conventional laser writers only write onto the printing substrate during constant motion of the printing head in the scan direction. However, it is realized as a part of the present disclosure that the printing efficiency can be further enhanced by also writing during acceleration and/or deceleration of the printing head (i.e., at the start and end of each scan). Aspects of the present disclosure are thus directed at enabling such writing during a non-constant motion of the printing head, which implementation has numerous associated difficulties, especially when it is important to maintain precision in writing nano-scale patterns.

Thus, according to an aspect of the present disclosure, there is provided a method of controlling a laser writer, moving a printing head in a scan direction relative to a printing substrate, wherein the movement of the printing head has a non-constant velocity profile, and directing one or more laser beams through a spatial light modulator, SLM, and towards the printing substrate.

The intensity of the one or more laser beams directed through the SLM is controlled according to one or more position triggers corresponding to predetermined positions of the printing head relative to the printing substrate, such that the SLM adopts an SLM array pattern corresponding to a printing pattern to be printed at a location on the printed substrate when the printing head is at said location on the printed substrate.

The printing pattern may comprise a nano-scale pattern for printing onto the printing substrate, where the printing substrate may comprise one or more materials that are affected/developed (e.g., shaped, colored, chemically altered such as polymer degradation, etc.) by the one or more laser beams. For example, the printing substrate may comprise a base substrate with a photoresist layer, and the printing substrate, having the pattern printed thereupon, may be used to form a photomask for use in the manufacture of electronic displays, for example.

The data pattern may comprise information for each of the one or more laser beams, and how they should vary in time during printing to generate the printed pattern on the printing substrate. The data pattern may vary between a lowest value and a highest value, which may correspond to a minimum and maximum intensity of the one or more laser beams, at least as used in the particular pattern being printed, or a minimum and maximum intended development of the printing substrate. The particulars of how the pattern to be printed is transformed into the data pattern are less relevant for understanding the present disclosure and are therefore not discussed in detail herein.

The relative motion between the printing head and the printing substrate may comprise an acceleration from a relative stationary position, e.g., at the initiation of the printing or the initiation of a particular scan of the printing head in the scan direction, and a deceleration to return to the relative stationary position. For this reason, and/or other reasons, the relative movement of the printing head and the printing substrate is non-constant, at least during these acceleration and deceleration stages.

It is realized as a part of the present disclosure that, whether or not the non-constant relative motion of the printing head and the printing substrate can be pre-determined, the effects of the non-constant relative motion to the printing output can be accommodated for, and hence printing can be carried out even during non-constant relative motion of the printing head and the printing substrate, thereby substantially increasing the printing efficiency of the laser writer. This is achieved at least by controlling the intensity of the one or more laser beams directed through the SLM according to one or more position triggers corresponding to predetermined positions of the printing head relative to the printing substrate.

As understood by those skilled in the art, the SLM may comprise an array of optical elements, such as rotatable mirrors, liquid crystals, etc., which may be arranged in a 1-dimensional (1D) array or a 2-dimensional (2D) array, depending on the implementation. As one example, a 1D SLM may comprise a plurality of aligned cuboidal crystals where the transmissive properties of each crystal can be controlled according to a voltage across said each crystal. In some examples, a complementary array of laser beams is incident upon the array of optical elements. In other examples, a single shaped beam is homogeneously illuminating all elements.

The SLM may be mounted in the printing head, or may be installed elsewhere in the optical train of the laser writer, depending on the form factor of the laser writer. As understood by those skilled in the art, the laser writer may further comprise a 'final' lens, as a last optical element in the optical train before the laser is incident upon the printing substrate. The details of the construction of the final lens, and other optical components in the laser writer, are, however, less relevant for the description of the present disclosure.

Controlling the intensity of the one or more laser beams may comprise changing the intensity of the beams using the controllable optical properties of each optical element of the SLM according to the data pattern. For example, the SLM may adopt an SLM array pattern corresponding to (a portion of) the data pattern such that laser beams passing through the SLM adopting such an SLM array pattern will, when incident upon the printing substrate, cause a printing pattern corresponding to (the portion of) the data pattern to be printed.

Controlling the intensity of the one or more laser beams may further comprise pulsing the laser beams. Hence, between pulses, the SLM array pattern can be changed to a different SLM array pattern.

According to aspects of the present disclosure, the changing of the SLM array pattern and/or the pulsing of the laser beam(s) are controlled based on position triggers corresponding to predetermined positions of the printing head relative to the printing substrate. Put another way, the changing of the SLM array pattern and/or the pulsing of the laser beam(s) are 'position-triggered'.

The position triggers may correspond to predetermined positions of the printing head relative to the printing substrate in that the position triggers may be associated with the data pattern and configured so that a portion of the printing pattern is printed at an intended location on the printing substrate. Viewed from one perspective, when the printing head is over a particular part of the printing substrate, where a first portion of the printing pattern is to be printed, the SLM is controlled to adopt an SLM array pattern based on a data pattern associated with said portion of the printing pattern. A position trigger may be associated with this particular part of the printing substrate such that when the printing head is aligned with this position trigger, the SLM is triggered to adopt the associated SLM array pattern and/or a pulsing of the laser is triggered. As an example, a position/distance measurement (e.g., from some set starting point) along the scan direction may be obtained by a position sensor on the printing head. A list of predetermined positions may be provided into a comparator, along with the position monitored by the position sensor, and the output of the comparator may then be provided to a controller to trigger the change of the SLM array pattern and/or a laser pulse.

Three example implementations of such an arrangement are disclosed herein, although it will be appreciated that further variations or combinations of the disclosed examples could be implemented.

According to a first example implementation, the SLM is a 1D SLM, and the SLM array pattern is a 1D SLM array pattern across the scan direction. According to this example, one or more substantially continuous laser beams is directed at the 1D SLM array pattern, and the SLM is controlled to change from a 1D SLM array pattern to a next 1D SLM array pattern in response to a position trigger.

Here, the one or more continuous laser beams may be a homogenized and/or shaped beam covering all pixels/mirrors of the SLM. The one or more continuous laser beams may be 'quasi-continuous', i.e., the pulse repetition rate may be high enough such that it can in some aspects be treated as continuous. In other aspects, the preserved pulsed property may be beneficial. Such a quasi-continuous laser may not be synchronized with the position triggers. In these cases, the pattern data is progressed with position triggers as with the purely continuous laser.

In other examples, the one or more laser beams are pulsed in response to a position trigger signal. It will be understood that the velocity profile of the printing head, the positions of the position triggers, and the timing of the pulses will have some relationship. For example, if the position triggers are evenly spaced along the scan direction, and the velocity profile of the printing head is non-constant, then the timing of the pulses will be similarly non-constant.

According to a second and third example implementation, the SLM is a 2-dimensional, 2D, SLM the SLM array pattern is a 2D SLM array pattern across and along the scan direction.

In the second example implementation, the pattern data is delivered to the SLM triggered by the carriage position in relation to the substrate, as in the first example, i.e., the 1D SLM embodiment. As the 2D SLM has a two-dimensional array of optical elements, a pulser laser must be used to ensure that the SLM array/image (pixel grid) is "stamped" onto the printing substrate when correct position is reached. Thus, in second example implementation, the laser pulses are also triggered based on the position.

This implementation may require the least changes to existing data processing and electronics having regard to a comparative example of a laser writer which cannot write during non-constant velocity motion of the printing head. However, externally triggered pulsed lasers that can be applied to SLM-based laser writers are currently not common.

Firstly, the repetition rate (i.e., the pulse frequency, or how often the pulses are delivered) of the pulsed laser should preferably be variable in such an example. Further, pulse frequency should preferably be variable in a large enough rate to match the different velocities of the non-constant velocity profile. Such lasers are currently unusual and more difficult to keep stable due to the varying average output power.

Such an arrangement may, however, be possible to implement by "pulse picking" from a high frequency oscillator train (-10-100 MHz) of pulses where only the required pulses are further amplified. One way to implement a pseudo-variable pulse frequency may comprise a pulsed laser with a pulse frequency substantially higher than that which would otherwise be expected to be used for a particular implementation, and selectively allowing through particular pulses based on position triggering.

In a third example implementation, a more common laser source, having a substantially fixed pulse repetition rate, may be used, but may be configured for externally triggered timings of the pulses. In this third example implementation, the laser pulse trigger positions may be calculated to correspond with the constant pulse frequency. When using a constant pulse repetition rate and a non-constant velocity, the SLM image will as a result be "stamped" at equal time intervals, but not at equal space intervals.

Thus, the pattern data delivered to the SLM may be compensated to match the spatial distance between the pulses. This can be done, for example, by partial loading of pattern data onto the SLM. The width (in the scan motion direction) of the stamp being printed can be adapted to the velocity based on the known trajectory. If the velocity is lower in the beginning of the strip, the number of optical elements in the SLM array (i.e., micromirrors/pixels) on the SLM in the scan direction that are loaded with data can be reduced to match the motion trajectory.

The illumination frequency of the SLM may be maintained throughout the scan, and since the printing substrate is exposed by a discrete number of laser pulses, the delivered dose will be correct. As above, when using a pulsed laser, the one or more pulsed laser beams may be a homogenized and/or shaped beam covering all pixels/mirrors of the SLM.

Put another way, according to the third example implementation, the non-constant velocity profile is predetermined, and the one or more position triggers are configured based on the predetermined non-constant velocity profile to thereby pulse the one or more lasers with a substantially uniform periodicity.

In some cases, the non-constant scan velocity may cause an inconsistent exposure of the printing substrate. Each printed pixel may have a width in the scan direction (where 'width' may be referred to as 'height' or `length' from different perspectives). It will be understood that, if a laser with constant intensity is incident upon a particular pixel with a lower velocity than an adjacent pixel, due to a non-constant motion of the printing head, then the laser will be incident upon said particular pixel for a longer time than said adjacent pixel. Hence, if the laser intensity is constant for both these pixels, then said particular pixel will be exposed more than said adjacent pixel. Therefore, according to some examples, the exposure dose is adjusted to compensate for non-constant velocity of the printing head. Such dose compensation may be particularly useful in a constant-laser 1D SLM example.

The exposure dose may be adjusted either by external modulation or internally in the SLM, e.g., using grayscale levels in the SLM. External modulation may be performed using an acousto-optical modulator (AOM), for example. That is, in some examples, where the non-constant velocity profile is predetermined, the laser writer control method further comprises comprising directing the one or more laser beams through an AOM to thereby further modulate the intensity of the one or more laser beams. In such examples, the AOM is controlled to modulate the intensity of the one or more laser beams based on the predetermined non-constant velocity profile.

In this way, if the one or more laser beams are directed at a particular unit area of the printing substrate (e.g., a pixel, which may be the smallest area unit used in the printing pattern) for a longer time as a result of a lower (average) velocity during an acceleration of the printing head relative to the printing substrate, the longer exposure time can be compensated for by controlling the modulating optic to reduce the relative intensity accordingly, such that the total incident energy is substantially the same as it would have been were the printing head and printing substrate moving with a constant velocity, as with conventional techniques.

As used above, the total incident energy on a unit area of the printing substrate may be referred to as the 'dose,' and may be controlled between 0 (or 0%, corresponding to no development of the unit area of the substrate) and 1 (or 100%, corresponding to a full development of the unit area of the substrate) according to the data pattern, or over 100% depending on the implementation. In some cases, the required dose as indicated in the data pattern may be some intermediate value, such as 50%. The relative dose may be scaled (e.g., reduced) according to the predetermined non-constant velocity profile so as to achieve, e.g., an effective 50% dose when the one or more laser beams are incident on a unit area for a longer time, owing to a lower average velocity.

Put another way, the modulating optic may be configured to vary the intensity, based on the predetermined non-constant velocity profile, to thereby achieve a substantially uniform relative laser exposure per unit area of exposed printing substrate.

Moving the printing head in the scan direction relative to the printing substrate may comprise moving the printing head relative to a static printing substrate, or moving the printing substrate relative to a static printing head. The position of the printing head (relative to the printing substrate) may be monitored using a position sensor. The position sensor may comprise an interferometer and/or an encoder.

Position triggering may comprise the use of a comparator, which may be provided with one or more positions at which a trigger should be generated. These trigger positions may be predetermined or dynamically determined in real time, depending on the implementation. When the printing head is determined to be at a trigger position, e.g., by the position sensor sensing a position that matches a trigger position, a trigger signal may be generated. As discussed above, the trigger signal may cause the SLM array pattern to change and/or may cause a laser to be pulsed.

The sensed position obtained by the position sensor may have one or more compensations applied thereto to obtain the monitored position, the one or more compensations being based on at least one predetermined position error. The position compensations may account for, for example, latency in communications, parallax errors, etc.

The aspect(s) of the present disclosure described above are directed towards a method for controlling a laser writer, and may be realized as a series of computer-readable instructions for carrying out by a processor. Hence, the method may be a computer-implemented method. In an example, a computer program or a (transitory or non-transitory) computer-readable medium may be formed with instructions which, when the program is executed by a computer, cause the computer to carry out the method.

According to a further aspect of the present disclosure, there is provided a laser writer, comprising a laser source (e.g., mounted on a printing head), an SLM, and a controller configured control the SLM to thereby control the intensity of one or more laser beams from the laser source directed through the SLM to carry out the method substantially as described above. The controller may further be configured to control the laser source, such as to trigger pulsing of the laser source, as discussed above.

One or more advantages discussed above, or further advantages, brought about by the above-described method may transfer as advantages of a laser writer implementing such a method. Such further advantages may already be apparent from the above discussion, although they are not explicitly stated. Moreover, such further advantages, or others, may be realized through appreciating specific implementations of aspects of the present disclosure, one or more of which are described below.

### Brief Description of the Drawings

One or more embodiments will be described, by way of example only, and with reference to the following figures, in which:
Figure 1A schematically shows an example laser writer, viewed side on, perpendicular to a scan direction;
Figure 1B schematically shows the laser writer from above, part-way through a printing operation;
Figure 1C shows a portion of the printing pattern being printed onto the printing substrate by the laser writer as shown in figures 1A and 1B;
Figure 1D shows a representation of portions of pattern data generated from the printing pattern shown in figure 1C;
Figure 2A schematically shows a printing pattern having been partially printed on a printing substrate according to an example illustrated data pattern, according to a first example implementation of the present disclosure;
Figure 2B illustrates an example non-constant velocity profile for the laser writer shown in 2A, with position triggers overlaid thereon corresponding to those shown in figure 2A;
Figure 3A schematically shows a printing pattern having been partially printed on a printing substrate according to an example illustrated data pattern, according to a second example implementation of the present disclosure;
Figure 3B illustrates an example non-constant velocity profile for the laser writer shown in 3A, with position triggers overlaid thereon corresponding to those shown in figure 3A;
Figure 4A schematically shows a printing pattern having been partially printed on a printing substrate according to an example illustrated data pattern, according to a third example implementation of the present disclosure;
Figure 4B illustrates an example non-constant velocity profile for the laser writer shown in 4A, with position triggers overlaid thereon corresponding to those shown in figure 4A;
Figure 4C illustrates another example non-constant velocity profile, with position triggers overlaid thereon, showing partial loading of the SLM pattern data;
Figure 5 illustrates a method for controlling a laser writer; and
Figure 6 schematically shows a position triggering scheme for a laser writer.

### Detailed Description

The present disclosure is described in the following by way of a number of illustrative examples. It will be appreciated that these examples are provided for illustration and explanation only and are not intended to be limiting on the scope of the disclosure.

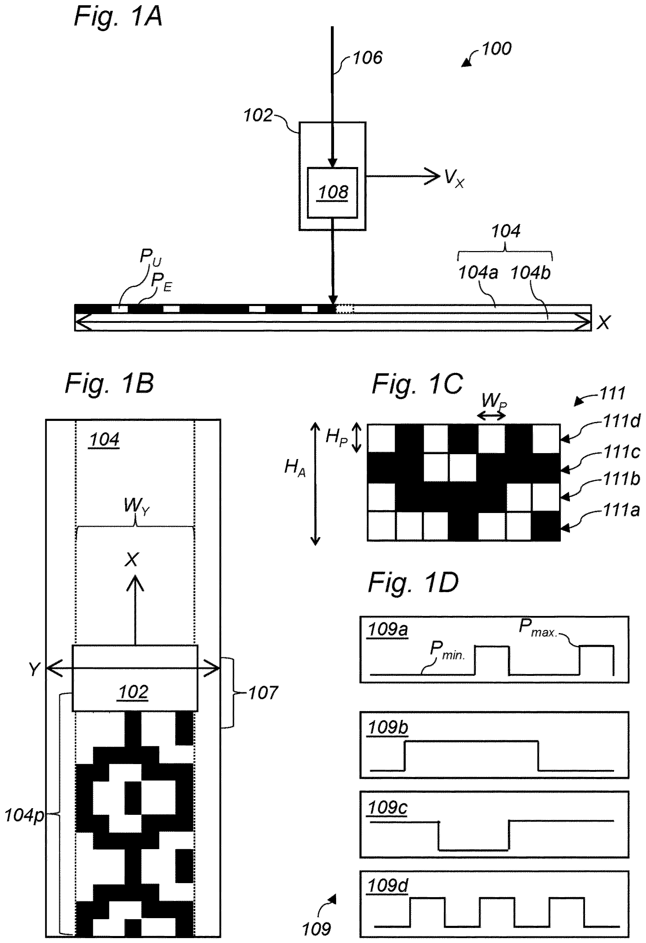

Figure 1 schematically shows an example laser writer 100 comprising a printing head 102 moving in a scan direction X relative to a printing substrate 104. In this example, the printing substrate 104 comprises a photoresist layer 104a on top of a base layer 104b. Herein, the printing substrate 104 may also be referred to as simply `substrate 104'.

The laser writer 100 is shown during a printing operation, wherein a laser beam 106 (also referred to herein as simply 'beam 106') is directed to a spatial light modulator (SLM) 108. As understood by those skilled in the art, the SLM may comprise a number of optical elements (i.e., micromirrors/crystals/pixels) arranged in a strip or array.

The beam 106 may originate from a laser source and may pass through one or more components between the laser source and the SLM 108. Furthermore, although the SLM 108 is shown as being in the printing head 102, it will be appreciated that this is purely schematic and the SLM 108 may be installed elsewhere on the laser writer 100. For the sake of the present discussion, the portion of the beam 106 entering the SLM 108 shall be considered as being substantially unmodified.

As discussed in more detail below, the SLM 108 is controlled according to a data pattern to modulate the intensity of the beam 106, where the data pattern corresponds to a printing pattern to be printed onto the printing substrate 104. In figure 1A, the pattern can be seen being printed onto the substrate 104, where the pattern is formed of a number of (substantially square) pixels, including unexposed pixels *P_{U}* and exposed pixels *P_{E}.* It will be appreciated that, in other examples, partially exposed pixels may form part of the pattern.

The printing head 102 is moved with a velocity *V_{X}* along the substrate 104 during printing. In this example, the printing head 102 is scanned along a static substrate 104. In other examples, the substrate 104 may be moved in addition or as an alternative to the motion of the printing head 102.

Figure 1B shows a top view of the laser writer 100, which more clearly shows the printed substrate 104p, having a printed pattern. In this example, the printing head 102 scans along the substrate 104 in the scanning direction *X* and, using the SLM 108, applies a plurality of 'stamps' to the printing substrate 104. Each 'stamp' corresponds to an array of pixels of the SLM 108 extending in the *Y*-direction, perpendicular to the scanning direction *X*. In this way, a width *W_{Y}* of the substrate 104 is exposed for each scan of the printing head 102 along the substrate 104 in the scanning direction *X*. In the illustrated example, it can be seen that the stamps being applies have a width of 7 pixels.

The height of the printed stamp may vary. The SLM array may, in some examples, be only one row of pixels, corresponding to a '1D SLM' arrangement. In other examples, the SLM may be more than one row of pixels, corresponding to a `2D SLM' arrangement. The beam 106 may be a plurality of beams (e.g., one for each pixel of the SLM 108) or the entire SLM 108 may be illuminated by a beam 106 that is homogenized and shaped to correspond to the entire SLM 108.

Figure 1C shows four rows 111a, 111b, 111c, 111d of a printing pattern 111 to be printed onto the substrate. The printing pattern 111 is shown made up of a plurality of pixels, having a height *H_{P}* and a width *W_{P}.* In this example, the pixels are square such that the height *H_{P}* and the width *W_{P}* are the same. It will be understood that the size of the pixels may be configured to correspond to a width of the beam 106, or vice versa.

In an example where the SLM 108 is a 1D SLM, each of the rows 111a, 111b, 111c, 111d is printed by a respective 'stamp' with the SLM 108 along the sweep direction Y. Hence, the SLM array pattern for each stamp may comprise seven different modulation intensities for the beam 106 (one for each pixel). In the illustrated example, the printing pattern 111 is entirely aligned to the pixel grid, and thus only requires an incident energy (or 'dose') of 0% laser intensity (white) or 100% laser intensity (black) to form. In other examples, the printing pattern 111 may be misaligned with the pixel grid for the laser writer 100, in which case some intermediate dose for a pixel may be used.

Example parts 109a, 109b, 109c, 109d of a data pattern 109 generated from the printing pattern are shown in figure 1D. Part 109a corresponds to row 111a, part 109b corresponds to row 111b, part 109c corresponds to row 111c, and part 109d corresponds to row 111d. Each part 109a, 109b, 109c, 109d may be provided in sequence to the control of the SLM 108 (as discussed in more detail below), such that the beam 106 is modulated during or before each stamp, corresponding to a respective row 111a, 111b, 111c, 111d of the printing pattern 109, to thereby print the printing pattern 109 onto the substrate.

As shown in figure 1D, the data pattern 109 may be constrained between a minimum, corresponding to a minimum laser intensity *Pₘᵢₙ.* and a maximum, corresponding to a maximum laser intensity *P_{max.}.* It can be seen that, by varying the intensity of the beam 106 according to, e.g., the part 109d of the data pattern 109 during a particular stamp, the row 111d of the printing pattern 111d may be printed onto the substrate 104.

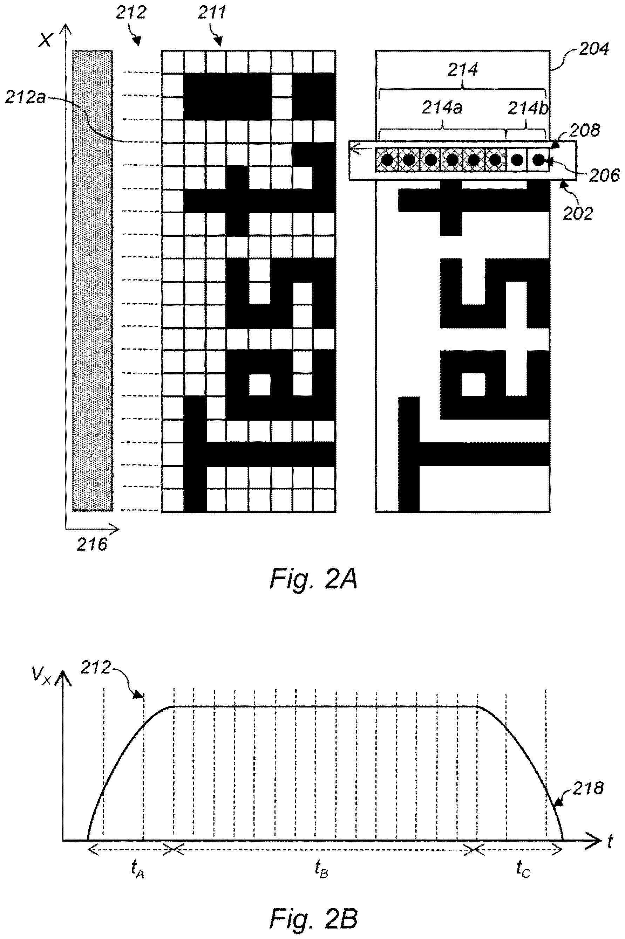

Three example implementations of such an arrangement are disclosed in figures 2A-B, 3A-B, and 4A-C, although it will be appreciated that further variations or combinations of the disclosed examples could be implemented.

According to a first example implementation, illustrated in figure 2, the SLM 208 is a 1D SLM 208, and the SLM array pattern 214 is a 1D SLM array pattern across the scan direction. According to this example, eight substantially continuous laser beams 206 are directed at the 1D SLM array pattern 214, and the SLM 208 is controlled to change from a first 1D SLM array pattern (e.g., that shown in figure 2A) to a next 1D SLM array pattern, in response to a position trigger.

Here, the plurality of laser beams 206 may instead be a homogenized and/or shaped beam covering all pixels of the SLM 208. In this example, the pixels of the SLM 208 are substantially square and aligned in a row. Further, in this example, the SLM array pattern 214 comprises a binary combination of 'off' pixels 214a, shown shaded in grey, and 'on' pixels 214b, shown unshaded. The 'off' pixels 214a may block the passage of the incident lasers 206, thereby resulting in no exposure of the printing substrate 204 below. The 'on' pixels 214b may substantially entirely allow the passage of the incident lasers 206, thereby resulting in a complete exposure of the printing substrate 204 below. This a purely schematic example, and it will be appreciated that the SLM array pattern 214 may further be configured to adopt intermediate states of 'grayscale'.

The pattern data 211 is shown with associated position triggers 212, arranged to coincide with the borders between each row of the data 211. The graph to the left of the data 211 indicates a continuous laser power throughout the scan. The alignment of the position sensor (not shown) is generally indicated by the arrow on the printing head 202 to the left of the SLM 208.

When the position of the printing head 202 is coincident with a position trigger 212, shown schematically aligned with the pattern data 211 and the printing substrate 204 for ease of understanding, the SLM 208 is triggered to change from a first SLM array pattern 214 to a next SLM array pattern.

It can be seen that, as the printing head 202 moves along the X direction on the printing substrate, the position trigger 212a will be reached. Immediately before, the SLM array pattern 214 corresponds to the row of the pattern data 211 before the position trigger 212a. Immediately after, the SLM array pattern 214 will change to correspond to the row of the pattern data 211 after the position trigger 212a. In this way, as shown in figure 2A, a printing pattern is printing onto the printing substrate, corresponding to the pattern data 211, as the printing head moves along the scan direction X.

Figure 2B illustrates the non-constant velocity profile 218 of the printing head 202. The velocity *V_{X}* of the printing head 202 along the scan direction X is shown evolving over time *t*.

As shown in figure 2A, the position triggers 212 are evenly spaced along the scan direction *X*. As shown in figure 2B, such even spacing leads to an uneven spacing in time *t*.

During the first time period *t_{A}*, the printing head 202 of the laser writer may be travelling at an increasing below-maximum velocity. As a result, the changes in the SLM array pattern may be triggered less often during this period.

In some examples, for example when the changes in velocity are quite large in the non-constant velocity profile, an AOM may compensate for a lower velocity motion over particular rows of pixels. Therefore, the relative dose during writing, e.g., per row, may be reduced to compensate for the increased amount of time that the laser is incident upon each row. Throughout the first time period *t_{A}*, the relative dose may be reduced less and less until the printing head reaches the maximum velocity at the start of the second time period *t_{B}*.

During the second time period *t_{B}*, the laser writer may be travelling at a maximum and constant velocity. Therefore, the frequency of triggers, the relative dose during writing, e.g., per row, may remain constant until the printing head begins to decelerate towards the end of the scan, at the start of the third time period *t_{C}*.

During the third time period *t_{C}*, the laser writer may be travelling at a decreasing below-maximum velocity. As a result, the changing of SLM array pattern may again be triggered less often during this period.

In some examples, a threshold velocity may be defined, below which the laser writer does not write. Hence, a portion at the start of the first time period *t_{A}* and a portion at the end of the third time period *t_{C}* may comprise time periods where the laser writer does not write.

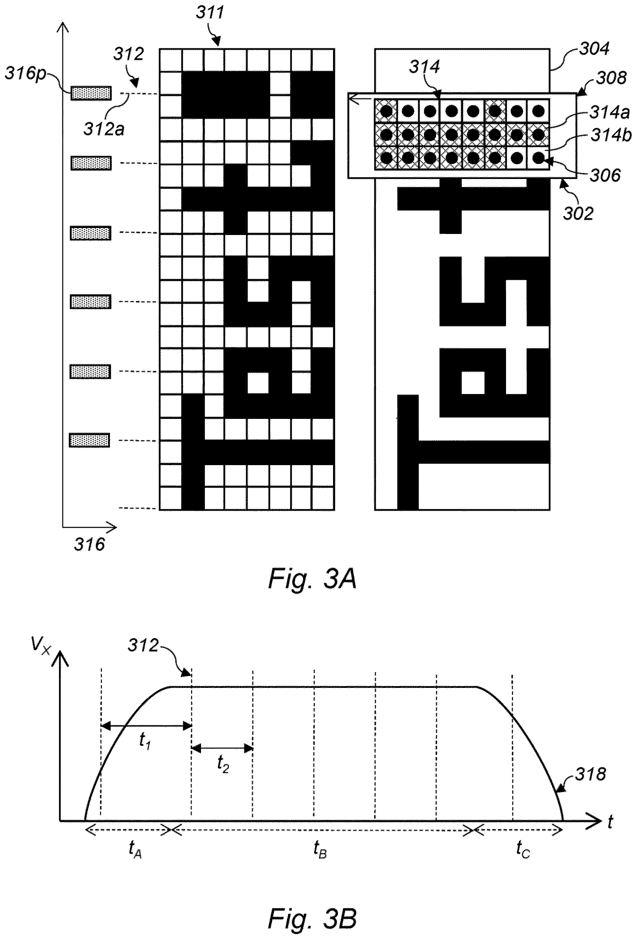

In the example shown in figure 3A-B, the laser beams 306 are pulsed (shown in the graph as pulses 316) in response to position trigger signals 312. Further, the SLM 308 is a 2D SLM 308 and the SLM array pattern 314 is a 2D SLM array pattern across and along the scan direction *X*. Furthermore, the position triggers 316 are evenly spaced along the scan direction X. Specially, the position triggers 312 are shown aligned with the pattern data 311 at every third row.

The 2D SLM 308 has a 2D SLM array pattern 314 that is eight pixels wide and three pixels high. It can be seen that, similarly to the SLM array pattern shown in figure 2A, there are 'off' pixels 314a shown shaded in grey, and 'on' pixels 314b shown unshaded.

The lasers 306 are shown during a pulse 316p, as the printing head 302 is shown at a position on the printing substrate 304 that corresponds to a position trigger 312a. At this position, the pulsed lasers 306 are incident upon the SLM 308, which adopts the SLM array pattern 314 corresponding to a portion of the pattern data 311 for that part of the printing pattern.

It will be understood that, as the lasers 306 are pulsed in response to the position triggers 312, the SLM array pattern 314 may be updated either at the same time as the pulsing (i.e., the change is triggered by the position triggers 312), or the SLM array pattern 314 may be updated before the lasers 306 are pulsed.

As shown in figure 3B, the velocity profile 318 of the printing head 302 is non-constant, such that the timing of the pulses 316 is also non-constant. That is, it can be seen that the time *t₁* between the first pulse and the second pulse is longer than the time *t₂* between the second pulse and the third pulse.

This implementation may require the least changes to existing data processing and electronics having regard to a comparative example of a laser writer which cannot write during non-constant velocity motion of the printing head. However, externally triggered pulsed lasers are currently not common.

Firstly, the repetition rate (i.e., the pulse frequency, or how often the pulses are delivered) of the pulsed laser 306 should preferably be variable in such an example. Further, pulse frequency should preferably be variable in a large enough rate to match the different velocities of the non-constant velocity profile 318. Such lasers are currently unusual and more difficult to keep stable due to the varying average output power.

Such an arrangement may, however, be possible to implement by "pulse picking" from a high frequency oscillator train (-10-100 MHz) of pulses where only the required pulses are further amplified. One way to implement a pseudo-variable pulse frequency may comprise a pulsed laser with a pulse frequency substantially higher than that which would otherwise be expected to be used for a particular implementation, and selectively allowing through particular pulses based on position triggering.

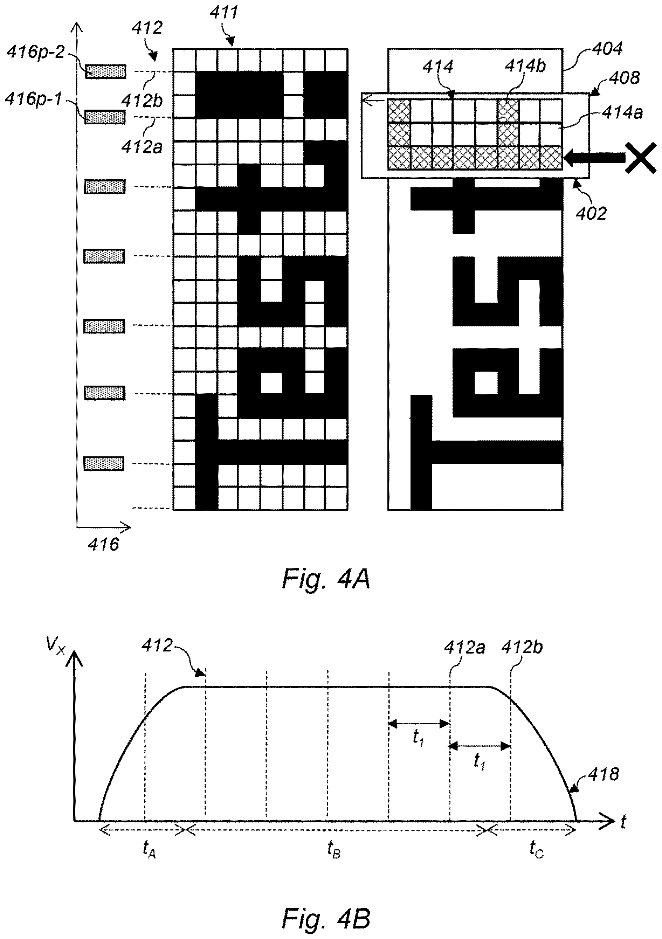

In a third example implementation, illustrated schematically in figures 4A-C, a more common laser source, having a substantially fixed pulse repetition rate, may be used, but may be configured for externally triggered timings of the pulses. In this third example implementation, the laser pulse trigger positions 412 may be calculated to correspond with the constant pulse 416 frequency. When using a constant pulse 416 repetition rate and a non-constant velocity 418, the SLM image will as a result be "stamped" at equal time intervals, but not at equal space intervals.

Thus, the pattern data 411 delivered to the SLM 408 may be compensated to match the spatial distance between the pulses 416. This can be done, for example, by partial loading of pattern data 411 onto the SLM 408. The width (in the scan motion direction *X*) of the stamp being printed can be adapted to the velocity *V_{X}* based on the known trajectory 418. If the velocity *V_{X}* is lower in the beginning of the strip, such as during time periods *t_{A}* and *t_{C}* as shown in figure 4B, the number of optical elements in the SLM array 414 (i.e., micromirrors/pixels) on the SLM 408 in the scan direction *X* that are loaded with data 411 can be reduced to match the motion trajectory 418.

In the example illustrated in figure 4A, it can be seen that the first two position triggers 412 shown, in the scan direction *X* are separated by two pixels. These first two position triggers 412 are during a lower velocity of the printing head 402. Subsequent position triggers 412, during the maximum and constant velocity of the printing head 402, are each separated by three pixels in the scan direction *X.*

When the printing head 402 is at a position corresponding to position trigger 412a, all of the SLM array pattern 414 may be active, i.e., the SLM 408 is fully loaded with a three by eight (3x8) array of pattern data 411. This pattern data 411 can be seen between the position trigger 412a and the previous position trigger 412.

When the position trigger 412a is reached, a laser pulse 416p-1 is triggered, thereby stamping a printing pattern corresponding to said portion of the pattern data 411 onto the printing substrate 404.

Between the position trigger 412a and the subsequent position trigger 412b, the printing head is travelling slower than before, e.g., as the printing head 402 decelerates towards the end of the scan/strip. The position trigger 412b is positioned closed to the previous position trigger 412a than the said position trigger 412a is from the position trigger 412 preceding that. This distance corresponds to two pixels in the scan direction *X* in this example.

When the next laser pulse 416p-2 is triggered by the position trigger 412b, the SLM 408 is only partially loaded, as shown in figure 4A by the entire lower row of the SLM array pattern 414 being blocked. only the upper two rows of the SLM array pattern 414 are loaded with a two by eight (2x8) array of pattern data 411. The laser is not illustrated in this figure because the printing head 402 is illustrated not yet aligned with the position trigger 412b. Hence, it will be understood that the SLM array pattern 414 is changed before the next pulse 416p-2 is triggered, in this example.

In this way, as shown in figure 4B, the position triggers 412, being irregularly spatially spaced, result in a substantially regular timing of the position triggers 412. That is, it can be seen that the time *t₁* between the pulse 416p-1 (triggered by trigger 412a) and the pulse 416p-2 (triggered by trigger 412b) is equal to the time *t₁* between the pulse 416p-1 and the previous pulse.

The illumination frequency of the SLM may be maintained throughout the scan, and since the printing substrate is exposed by a discrete number of laser pulses, the delivered dose will be correct.

Put another way, according to this third example implementation, the non-constant velocity profile 418 is predetermined and the one or more position triggers 412 are configured based on the predetermined non-constant velocity profile 418 to thereby pulse the one or more lasers with a substantially uniform periodicity.

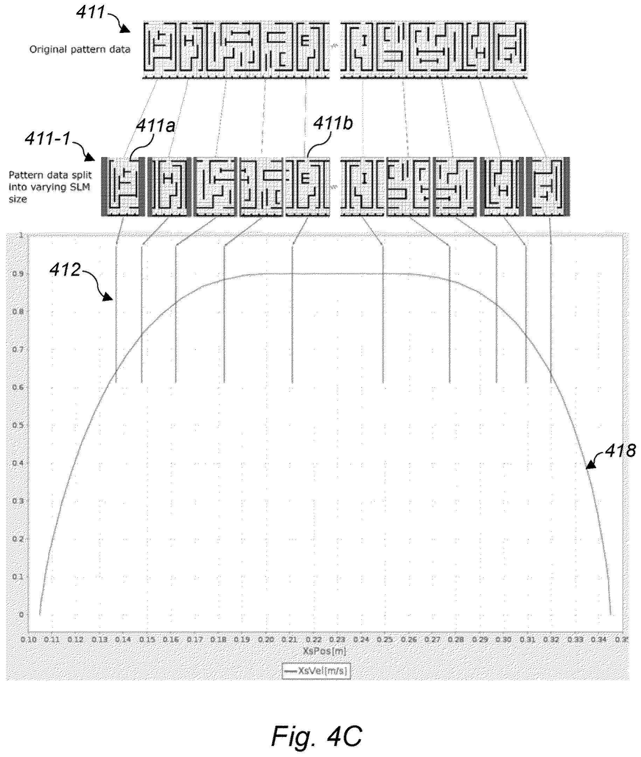

Figure 4C shows another view of the third example implementation, i.e., with partial loading of the SLM 408. The original pattern data 411 is shown portioned into irregular portions.

For example, a first portion 411a of the pattern data 411 is shown with greyed out edges, representing portions of the SLM 408 that are not loaded with data 411, such that only a central portion of the SLM 408 is loaded with a subset of the total possible data 411 that could be loaded onto the SLM 408.

Another graph of the non-constant velocity profile 418 for the printing head 402 is shown in figure 4C, showing the evolution of the velocity in units of meters per second, m/s, (where the maximum velocity is approximately 0.9 m/s), evolving with distance 'XsPos' along the scan direction *X.* Position triggers 412 are overlaid onto this graph. The position triggers 412 are irregularly spaced along the position axis, as discussed above. The spacing of these triggers 412 is, however, configured to result in a substantially regular period of pulsing of the laser.

The portion 411a of the pattern data 411 corresponds to a below-maximum velocity of the printing head 402, and hence the SLM 408 is partially loaded.

Another portion 411b of the pattern data corresponds to a maximum velocity of the printing head 402, and hence the SLM 408 is fully loaded with pattern data 411, as indicated by none of the portion 411b of pattern data 411 being greyed out.

The portions of pattern data 411 between the portions 411a and 411b are shown with more and more loading of the SLM 408 with pattern data 411, as the printing head 402 increases in speed. The spacing between position triggers 412 correspondingly increases. It will be appreciated that the spacing between position triggers 412 corresponds to a width of the stamp that is applied by the partially loaded SLM, such that each stamp is aligned and adjacent the previously applied stamp, irrespective of the loading of the SLM 408.

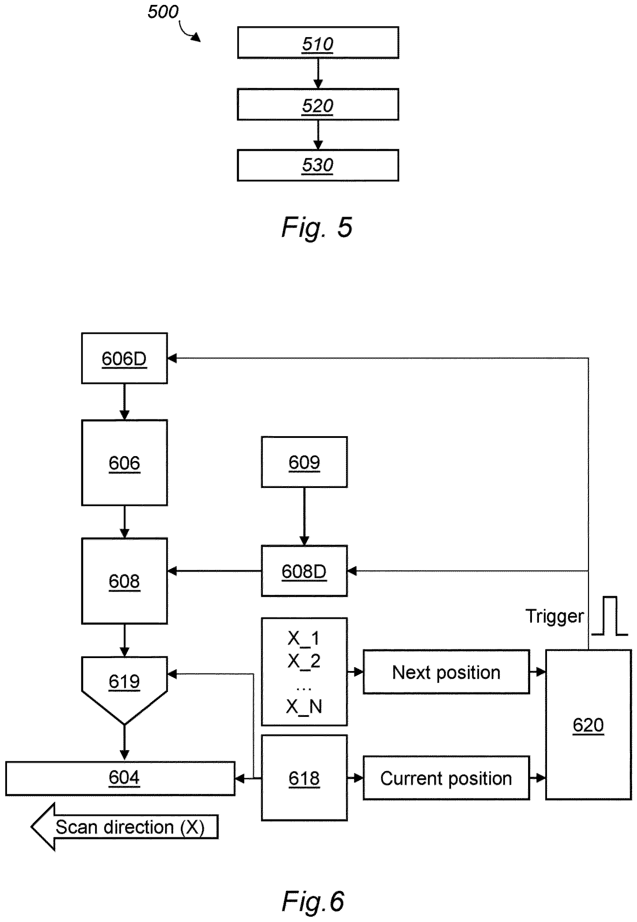

Figure 5 illustrates a general method 500 for controlling a laser writer, corresponding to aspects of the present disclosure. The method 500 comprises moving 510 a printing head in a scan direction relative to a printing substrate, wherein the movement of the printing head has a non-constant velocity profile. The method 500 further comprises directing 520 one or more laser beams through an SLM, and towards the printing substrate, and controlling 530 the intensity of the one or more laser beams directed through the SLM according to one or more position triggers corresponding to predetermined positions of the printing head relative to the printing substrate, such that the SLM adopts an SLM array pattern corresponding to a printing pattern to be printed at a location on the printed substrate when the printing head is at said location on the printed substrate.

The method 500 may be specifically implemented in any number of ways, such as through the example implementations discussed above.

The method 500 may be stored as instructions in a memory and may be carried out by a controller. The controller may be configured to control the SLM and/or the laser, and/or the printing head (e.g., the motion thereof) to thereby cause the laser writer to carry out the method 500. In some examples, a laser writer may be retrofitted with the capabilities of the method, to thereby increase its printing efficiency.

Figure 6 schematically shows an example position triggering arrangement. As discussed before, a laser 606 is directed through an SLM 608, which adopts an SLM array pattern, before the laser is incident upon a final lens 619 before being incident upon a printing substrate 604, thereby printing onto the printing substrate 604.

An SLM driver 608D is controlled to vary the intensity of the laser beam(s) according to pattern data 409. The pattern data 409 may be portioned into a plurality of portions corresponding to each stamp/array pattern. As discussed in association with figures 4A-C, the portions may be uneven.

A laser driver 606D is configured to drive the laser. If the laser 606 is a pulsed laser, the laser driver 606D may control when and how the laser 606 is pulsed.

In this example, to enact position triggering of stamps, which may involve a triggering of a change of the SLM array pattern and/or a pulsing of the laser, the arrangement further comprises a position sensor 618, configured to sense the position of the printing head (e.g., the final lens 619 thereof) relative to the printing substrate 604. The position sensor 618 may comprise an interferometer and an encoder. The position sensor 618 provides information of the current position to a comparator 620.

Also provided to the comparator 620 is a list of trigger positions X_1, X_2, ..., X_N, which may be predetermined and stored in a data storage. The trigger positions may be associated with the pattern data 609, synchronized with the pattern data 609, or may be part of a separate data stream. The trigger positions may correspond to a distance along the scan direction X for a particular scan/strip along the printing substrate 604, and thus the trigger positions may be one-dimensional (i.e., only in the X-direction). In other examples, the trigger positions may be two-dimensional.

When the comparator 620 determines that the current position corresponds to a trigger position (e.g., X_1), a trigger signal is generated and provided to the SLM driver 608D and/or the laser driver 606D. The trigger signal thus causes a change of configuration of the SLM array pattern by the SLM driver 608D and a portion of the pattern data 609 is encoded into the laser 606 during said stamp by the SLM driver 408D. The SLM 608 may adopt the new SLM array pattern in direct response to the trigger signal, or at a time after the trigger signal and before the next trigger signal, depending on the implementation.

In some examples, as discussed above, the trigger signal may cause a triggering of a pulsed laser 606 by the laser driver 606D. In such cases, the pulsed laser is preferably triggered immediately in response to the trigger signal. Compensations to the timing/position sensor etc. may be added to account for latency or other known or estimated errors.

In this way, the stamping of the pattern is triggered based on the position of the printing head relative to the printing substrate 604. Therefore, the non-constant velocity profile of the printing head relative to the printing substrate 604 can be advantageously accounted for, and printing can be performed even during periods of acceleration. Hence, the printing efficiency can be greatly enhanced.

While the present disclosure is susceptible to various modifications and alternative forms, specific embodiments are shown and described by way of example in relation to the drawings, with a view to clearly explaining the various advantageous aspects of the present disclosure. It should be understood, however, that the detailed description herein and the drawings attached hereto are not intended to limit the disclosure to the particular form disclosed. Rather, the intention is to cover all modifications, equivalents, and alternatives falling within the scope of the following claims.

## Claims

1. A method for controlling a laser writer, comprising:
moving a printing head in a scan direction relative to a printing substrate, wherein the movement of the printing head has a non-constant velocity profile;
directing one or more laser beams through a spatial light modulator, SLM, and towards the printing substrate; and
controlling the intensity of the one or more laser beams directed through the SLM according to one or more position triggers corresponding to predetermined positions of the printing head relative to the printing substrate, such that the SLM adopts an SLM array pattern corresponding to a printing pattern to be printed at a location on the printed substrate when the printing head is at said location on the printed substrate.

2. The method according to claim 1, wherein the SLM is a 1-dimensional, 1D, SLM, and the SLM array pattern is a 1D SLM array pattern across the scan direction, wherein one or more substantially continuous laser beams is directed at the 1D SLM array pattern, and wherein the SLM is controlled to change from a 1D SLM array pattern to a next 1D SLM array pattern in response to a position trigger.

3. The method according to claim 1, wherein the one or more laser beams are pulsed in response to a position trigger signal.

4. The method according to claim 3, wherein the SLM is a 2-dimensional, 2D, SLM the SLM array pattern is a 2D SLM array pattern across and along the scan direction.

5. The method according to claim 3 or claim 4, wherein the non-constant velocity profile is predetermined, and the one or more position triggers are configured based on the predetermined non-constant velocity profile to thereby pulse the one or more lasers with a substantially uniform periodicity.

6. The method according to any preceding claim, wherein the non-constant velocity profile is predetermined, and further comprising directing the one or more laser beams through an acousto-optic modulator, AOM, to thereby further modulate the intensity of the one or more laser beams, wherein the AOM is controlled to modulate the intensity of the one or more laser beams based on the predetermined non-constant velocity profile.

7. The method according to claim 6, wherein the AOM is configured to vary the intensity, based on the predetermined non-constant velocity profile, to thereby achieve a substantially uniform relative laser exposure per unit area of exposed printing substrate.

8. The method according to any preceding claim, wherein the SLM is mounted in the printing head.

9. The method according to any preceding claim, wherein moving the printing head in the scan direction relative to the printing substrate comprises moving the printing head relative to a static printing substrate, or moving the printing substrate relative to a static printing head.

10. The method according to any preceding claim, wherein the position of the printing head is monitored using a position sensor, and wherein the position sensor comprises an interferometer and/or an encoder.

11. The method according to claim 10, wherein a sensed position obtained by the position sensor has one or more compensations applied thereto to obtain the monitored position, the one or more compensations being based on at least one predetermined position error.

12. A laser writer comprising:
a laser source;
an SLM; and
a controller configured to control the SLM to thereby control the intensity of one or more laser beams from the laser source directed through the SLM,
wherein the controller is configured to control the SLM to carry out the method according to any preceding claim.
